**Europäisches Patentamt**

**European Patent Office**

**Office européen des brevets**

(19)

(11) Veröffentlichungsnummer : **0 012 985**

**B1**

(12) **EUROPÄISCHE PATENTSCHRIFT**

(45) Veröffentlichungstag der Patentschrift :
30.03.83

(21) Anmeldenummer : **79105254.1**

(22) Anmeldetag : **18.12.79**

(51) Int. Cl.³ : **H 03 K 13/20**

(54) **Dual-Slope-Integrator.**

(30) Priorität : **21.12.78 DE 2855282**

(43) Veröffentlichungstag der Anmeldung :
**09.07.80 Patentblatt 80/14**

(45) Bekanntmachung des Hinweises auf die Patenterteilung : **30.03.83 Patentblatt 83/13**

(84) Benannte Vertragsstaaten :
**FR GB NL**

(56) Entgegenhaltungen :
**DE A 1 935 124**
**DE B 1 298 546**
**FR A 1 586 885**
**FR A 2 029 837**
**FR A 2 208 251**
**GB A 1 158 877**
**RADIO MENTOR ELECTRONIC, Band 36, Nr. 2,**
**Februar 1970, München, DE, « Ein Doppelzyklus-**
**Digitalvoltmeter in Doppelflankentechnik », Sei-**
**ten 106-107**
**IBM TECHNICAL DISCLOSURE BULLETIN, Band**
**11, Nr. 4, September 1968, New York, US, WAL-**
**TON : « Triple ramp analog-to digital converter**
**with reverse direction third ramp », Seiten 384-**
**385**

(73) Patentinhaber : **Kernforschungsanlage Jülich Gesell-**
**schaft mit beschränkter Haftung**
**Postfach 1913**
**D-5170 Jülich (DE)**

(72) Erfinder : **Labus, Herwig, Dr. Dipl.-Phys.**
**Petternicherstrasse 9a**
**D-5170 Jülich (DE)**

(74) Vertreter : **Paul, Dieter-Alfred, Dipl.-Ing.**
**Erftstrasse 82**
**D-4040 Neuss 1 (DE)**

Dual-Slope-Integrator

Die Erfindung betrifft einen Dual-Slope-Integrator mit Eingangsschaltern für eine Meßspannung und eine Bezugsspannung, mit einem Integrator mit zumindest einem Integrationskondensator, mit einem Komparator zur Überwachung der Spannung des Integrationskondensators, mit einem Taktgenerator zur Erzeugung von Zählimpulsen, mit einem Zähler der Kapazität $N_1$ zur Zählung dieser Impulse und mit einer logischen Steuerschaltung, die eine Torschaltstufe für die Taktimpulse enthält und in Abhängigkeit von dem Komparatorausgangssignal die Torschaltstufe sowie die genannten Eingangsschalter steuert, wobei innerhalb der Steuerschaltung die Schaltstufen für die Eingangsschalter durch die Taktimpulse tastbar sind.

Ein Dual-Slope-Integrator dieses Aufbaues ist aus der FR-A-2 029 837 bekannt. Bei diesem Dual-Slope-Integrator wird der Integrationskondensator durch Umschaltung auf eine Bezugsspannung bis auf eine positive Restspannung entladen, die durch eine positive Restspannung entladen, die durch eine Hilfsschwelle vorgegeben wird. Die verbleibende Restspannung wird dann in einem weiteren Integrator wieder verstärkt und aufintegriert. Aus beiden Meßzyklen wird dann das gemeinsame Ergebnis gebildet.

Bei diesem Integrator wirkt sich nachteilig aus, daß eine Hilfsschwelle vorgesehen ist, die die Abintegration beendet. Hierdurch können Fehler entstehen, wenn die Hilfsschwelle nicht sehr zeitstabil ist, was durch eine aufwendige Schaltung gewährleistet werden muß. Weiterhin ist von Nachteil, daß für die Integration der Restspannung ein zweiter Integrator vorgesehen ist. Dieser muß genau auf den ersten Integrator abgeglichen sein, damit nicht auch hier Meßwertverfälschungen auftreten. Davon abgesehen, ist der Schaltungsaufwand entsprechend hoch.

Ein Dual-Slope-Integrator der eingangs genannten Art ist auch im IBM Technical Disclosure Bulletin, Band 11, Nr. 4, September 1968, Seiten 384-385 (Walton : « Triple ramp analog-to-digital converter with reverse direction third ramp ») beschrieben. Im Unterschied zum Dual-Slope-Integrator nach der FR-A-2 029 837 wird bei diesem Integrator bis zum Nulldurchgang abintegriert. Es verbleibt dann noch eine negative Restspannung, die dann durch Aufschaltung einer zweiten Bezugsspannung abintegriert wird. Da diese zweite Bezugsspannung etwa um den Faktor 100 kleiner sein muß als die erste, ergibt sich ein sehr flacher Nulldurchgang bei der Abintegration. Rauschen und Zeitgitter verschmieren diesen Nulldurchgang so stark, daß dessen exakte Erfassung nicht möglich ist. Entsprechende Ungenauigkeiten bei der Meßwerterfassung sind die Folgen.

In der Veröffentlichung Radio Mentor Electronic, Band 36, Nr. 2, Februar 1970, Seiten 106-107, « Ein Doppelzyklus-Digitalvoltmeter in Doppelflankentechnik » ist ein Doppelzyklus-Digitalvoltmeter offenbart, bei dem zuerst die unbekannte Spannung durch einen Doppelflankenwandler grob gemessen wird, indem in einem Integrator aufintegriert und anschließend durch Abintegration der Bezugsspannung ein Zeitwert ermittelt wird, der in die unempfindlichsten Dekaden gespeichert wird. Das in diesen Dekaden eingezählte Resultat wird über einen Kompensator in eine analoge Spannung umgewandelt und durch entsprechende Umschaltung eine Differenzbildung mit der dann um den Faktor 1 000 verstärkten Eingangsspannung bewirkt. Anschließend wird eine der ersten entsprechende zweite Messung durchgeführt und das Resultat in die drei empfindlicheren Dekaden eingezählt. Das aus beiden Teilresultaten zusammengesetzte Gesamtresultat wird angezeigt.

Nachteilig bei dieser Art der Meßwerterfassung ist die Tatsache, daß bei Einleitung des zweiten Meßzyklus eine Differenzbildung mit der dann herrschenden Eingangsspannung vorgenommen wird. Diese kann sich aber während des ersten Meßzyklus schon geändert haben, so daß die Messung ungenau wird. Außerdem muß die Schaltung sehr exakt ausgeführt sein, da sie hohe Anforderungen an die differenzielle und integrale Nichtlineariät stellt. Die Anforderungen sind dabei kaum realisierbar, um die gewünschte Endauflösung im zweiten Meßzyklus zu erreichen.

In der FR-A-2 208 251 ist ein Analog-Digital-Umwandler beschrieben, bei dem die gemessene Spannung in einem ersten Meßzyklus auf einen ersten Kondensator geladen wird, wobei jedoch keine Integration über einen bestimmten Zeitbereich erfolgt. Dieser wird anschliessend bis auf eine Restspannung entladen, die dann in einem zweiten Meßzyklus nach Verstärkung auf einen zweiten Kondensator gegeben wird. Durch Zusammensetzung der beiden Meßergebnisse erhält man den genauen Meßwert.

Die Nachteile dieses Umwandlers entsprechen denen des Integrators nach der FR-A-2 029 837 und bestehen auch hier in der zeitstabilen Anordnung einer Hilfsschwelle und in dem genauen Abgleich der für die beiden Meßzyklen vorgesehenen Schaltkreise.

Der Erfindung liegt die Aufgabe zugrunde, einen Integrator der eingangs genannten Art zu schaffen, der bei einem einfachen Aufbau exakte Messungen ohne Abgleichprobleme zuläßt.

Diese Aufgabe wird erfindungsgemäß dadurch gelöst, daß ein zweiter Zähler der Kapazität $N_2$ mit dem ersten Zähler zwecks Bildung eines Zählers der Gesamtkapazität $N_1 \times N_2$ in Reihe schaltbar ist, daß an den Ausgang des Integrationskondensators über einen Verstärker mit dem Verstärkungsgrad $N_2^* = N_2$ und einem Schalter ein Haltekondensator angeschaltet ist und daß der Haltekondensator über einen weiteren Schalter an den Eingang des Integrators anschaltbar ist, wobei die Schalter ebenfalls durch Taktimpulse tastbar sind und nach dem ersten Nulldurchgang der Bezugsspannung schaltbar sind, damit die Restspannung des Integrators um den Verstärkungsfaktor $N_2^*$ verstärkt für einen weiteren Meßzyklus auf den Eingang zurückgeführt wird und gleichzeitig die beiden Zähler hintereinander geschaltet werden, damit in dem weiteren Meßzyklus unter dem Einfluß der Bezugsspannung in dem Zähler der Zählerstand $Z_1 \times N_2 - Z_2$ gebildet wird.

Dieser Dual-Slope-Integrator zeichnet sich dadurch aus, daß der zweite Meßzyklus nach entsprechender Verstärkung der Restspannung über denselben Integrator abläuft wie der erste Meßzyklus, wobei die einzelnen Umschaltungen durch die Taktimpulse bewirkt werden. Hinzu kommt, daß für den Schaltimpuls des Komparators in an sich bekannter Weise der Nulldurchgang herangezogen wird. Damit entfallen die Probleme, die bei dem Umwandlern mit Hilfsschwelle auftreten können, abgesehen davon, daß die Schaltung nach der Erfindung einen relativ einfachen Aufbau hat. Außerdem enthält man in beiden Meßzyklen Nulldurchgänge in gleicher Steigung, so daß Verschmierungen des Nulldurchgangs nicht auftreten können.

Zur Unterdrückung von Störimpulse ist vorgesehen, daß innerhalb der logischen Steuerschaltung zur Schaltung der Taktimpulse eine Verzögerungsschaltung vorgesehen ist, deren Ausgangsschaltimpuls gegenüber der dem Komparatornulldurchgang folgenden Flanke des Taktgenerators eine feste Verzögerung besitzt, die größer ist als die Breite von Störimpulsen, und daß eine der Verzögerungszeit entsprechende feste Impulszahl durch Verlängerung der Rückwärtszählung des Zählers am Ende des zweiten Meßzyklus subtrahiert wird. Damit die Schaltzeiten unabhängig von Störungsspannungen und Schaltzeiten der Eingangsschalter festgelegt sind, sieht die Erfindung des weiteren vor, daß vor der virtuellen Erde des Integrators ein Schalter vorgesehen ist, der ausschließlich den Zeitpunkt von Beginn und Ende der Integrationszyklen bestimmt.

Im einzelnen ist der Schalter als Brückenschaltung aus schnellen Schaltdioden aufgebaut.

Damit die Integration von den Einschwingzeiten der Operationsverstärker unabhängig ist, schlägt die Erfindung ferner vor, daß als Integrator eine spannungsgesteuerte Stromquelle vorgesehen ist, an deren Ausgang ein schneller Brückenschalter und in Reihe zu demselben der Integrationskondensator angeschaltet ist.

Bei dieser Ausbildung ist der schnelle Brückenschalter auf Durchgang schaltbar, wenn alle Einschwingvorgänge der Stromquelle und der Eingangsschalter abgeklungen sind.

Schließlich sieht eine Bemessung verschiedener Schaltglieder vor, daß der Integrationswiderstand $R_I$, der Integrationskondensator I, die Taktfrequenz f des Taktgenerators und der Verstärkungsfaktor $N_2^*$ so festgelegt sind, daß die Beziehung gilt :

$$\frac{R_I \times C_I \times f}{N_2^*} = 1$$

Dadurch ergibt sich eine besonders einfache Bestimmung des Signalwertes, ohne zusätzliche Berechnung.

Ausführungsformen der Erfindung werden im folgenden unter Bezugnahme auf die anliegenden Zeichnungen erläutert, in denen darstellen :

Figur 1 ein Diagramm für den Verlauf der Integratorausgangsspannung und der Taktimpulse im Bereich des Nulldurchgangs,

Figur 2 einen Dual-Slope-Integrator nach der Erfindung und

Figur 3 eine abgewandelte Ausführungsform eines Dual-Slope-Integrators nach der Erfindung.

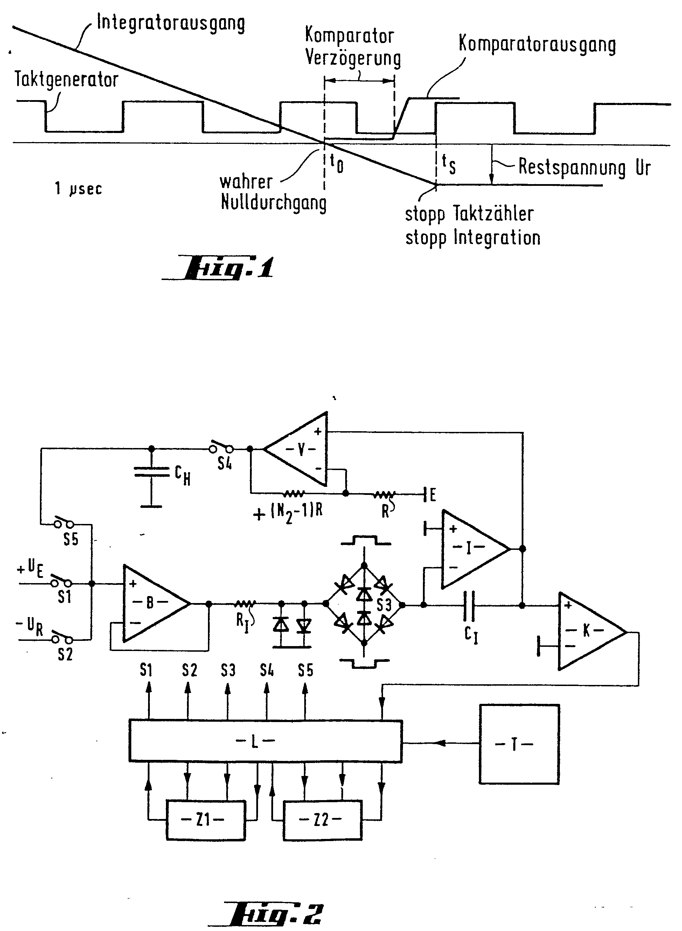

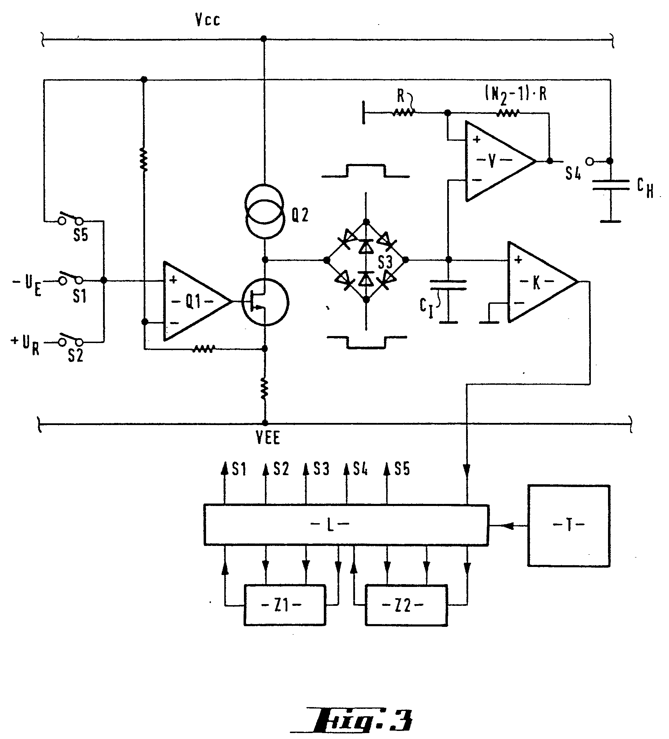

Fig. 2 zeigt einen Dual-Slope-Integrator nach der Erfindung. Feldeffekt-Eingangsschalter S1, S2 sind durch eine Steuerschaltung L gesteuert und schalten die Meßspannung oder Eingangsspannung sowie die Bezugsspannung durch. Diese Schalter sind an den Eingang eines Trennverstärkers B angeschaltet. Der Trennverstärker B ist mit Rückkoppelung als Operationsverstärker aufgebaut. An den Trennverstärker B schließt sich ein Integrationswiderstand $R_I$ an, der über einen schnellen Brückenschalter S3 mit einem Integrationskondensator $C_I$ verbunden ist. Der schnelle Brückenschalter ist mit Hot-Carrier-Dioden aufgebaut und wird durch eine potentialfreie Signalquelle gesteuert. Die Integration erfolgt mithilfe eines Integrations-Operationsverstärkers I. Der Ausgang des Integrations-kondensators $C_I$ ist an einen Komparator K angeschlossen, dessen Ausgang zu der Steuerschaltung L führt. Ein Taktgenerator T ist ebenfalls an die Steuerschaltung L angeschlossen. An die Steuerschaltung L sind zwei Zähler Z1 und Z2 mit einer Zählkapazität $N_1$ bzw. $N_2$ angeschlossen. Die Zähler Z1 und Z2 sind in Reihe schaltbar, so daß man einen Zähler Z1 + Z2 mit einer Gesamtkapazität $N_1 \times N_2$ erhält. Der Ausgang des Integrationskondensators $C_I$ ist an einen Verstärker V angeschlossen, der einen Verstärkungsgrad $N_2^* = N_2$ hat. Die Größen der Widerstände des Rückkoppelungsnetzwerkes sind in Fig. 2 angegeben. Der Ausgang des Verstärkers V ist über einen Schalter S4 mit einem Haltekondensator $C_H$ verbunden. Eine Belegung des Haltekondensators $C_H$ ist über einen Schalter S5 mit dem Eingang des Trennverstärkers B verbindbar. Die Schalter S1 ... S5 werden durch die Steuerschaltung L gesteuert.

Der Dual-Slope-Integrator nach der Erfindung arbeitet in zwei Meßzyklen, und zwar im einzelnen in folgender Weise :

Erster Meßzyklus :

1.1 Die unbekannte Eingangsspannung wird an den Integratoreingang gelegt und bis zum Überlauf des ersten Zählers Z1 mit dem Überlaufwert $N_1$ integriert, wobei $N_1$ eine ganzzahlige Potenz der Basiszahlen 10 oder 2 sei.

1.2 Die Bezugsspannung wird an den Integratoreingang gelegt, der Zähler Z1 wird zugleich gestartet.

1.3 Der Zähler Z1 wird nicht wie bekannt durch das Komparatorausgangssignal gestoppt, sondern die dem Komparatorausgangssignal nachfolgende Flanke des Taktgenerators schaltet die Bezugsspannung ab und hält den mit ihr auftretenden Inhalt $Z_1$ im Zähler Z1 fest.

1.4 Die beim Abschalten der Bezugsspannung am Integratorausgang festgehaltene Restspannung wird um einen Faktor $N_2^* = N_2$, wobei $N_2$ ebenfalls eine ganzzahlige Potenz der Basiszahlen 10 oder 2 sei, nachverstärkt und mit einem Haltekreis gespeichert.

Zweiter Meßzyklus :

2.1 Die um $N_2$ nachverstärkte Restspannung wird an den Integratoreingang gelegt und bis zum Überlauf des zweiten Zählers Z2 mit dem Überlaufwert $N_2$ integriert.

2.2 Der Ausgang des Zählers Z2 wird mit dem Eingang des Zählers Z1 verbunden, so daß in dem so gebildeten Zähler Z3 = Z1 + Z2 mit dem Überlaufwert $N_1 \cdot N_2$ der Inhalt $Z_1$ des ersten Meßzyklus mit dem Faktor $N_2$ multipliziert erscheint.

2.3 Der Zähler Z3 wird auf Rückwärtszählen umgeschaltet. Die Bezugsspannung wird an den Integratoreingang gelegt, der Zähler Z3 wird zugleich gestartet.

2.4 Der Zähler Z3 wird wie unter 1.3 beschrieben beim Inhalt $(Z_1 \cdot N_2 - Z_2)$ gestoppt.

Bei einem bekannten Dual-Slope-Integrator gilt zwischen der Eingangsspannung $U_E$ und dem Inhalt Z des Zählers am Ende des Meßzyklus die Beziehung :

$$U_E = U_R \cdot \frac{Z}{N} \qquad (1)$$

wobei $U_R$ die Bezugsspannung und N den Überlaufwert des Zählers bedeuten. Durch quantitative Formulierung der einzelnen Schritte der Signalverarbeitung nach der Erfindung ergibt sich eine der Gleichung (1) entsprechende Beziehung :

$$U_E = U_R \cdot \frac{(Z_1 \cdot N_2 - Z_2 \cdot F)}{N_1 \cdot N_2} \qquad (2)$$

wobei

$$F = \frac{R_I \cdot C_I \cdot f}{N_2^*} = 1$$

Es bedeuten : $U_E$ die unbekannte Eingangsspannung ; $U_R$ die Bezugsspannung ; $N_1$ bzw. $N_2$ Überlaufwerte der Zähler Z1 bzw. Z2 ; $Z_1$ bzw. $Z_2$ Zählstände während der Bezugsspannungsintegration des ersten bzw. zweiten Meßzyklus ; F ein Produkt aus analogen Größen wie : $R_I$ Integrationswiderstand, $C_I$ Integrationskondensator, f Taktfrequenz und $N_2^*$ Nachverstärkungsfaktor der Restspannung des ersten Meßzyklus.

Der Ausdruck A = Z/N aus Gleichung 1 wird in Gleichung 2 durch den scheinbar komplizierteren Ausdruck B = $(Z_1 \cdot N_2 - Z_2 \cdot F)/(N_1 \cdot N_2)$ ersetzt. Es gilt jedoch :

a) Der Ausdruck B läßt sich in der beschriebenen Weise schnell und direkt innerhalb der Schaltung bilden. Multiplikationsvorgänge und Subtraktionsvorgänge in gesonderten Schaltkreisen können entfallen.

b) Der Faktor F im Ausdruck B muß 1,0 sein, damit $U_E$ proportional zur Zahl $(Z_1 \cdot N_2 - Z_2)$ wird, die am Ende des zweiten Zyklus im rückwärtszählenden Zähler Z3 auftritt. Durch geeignete Wahl der Größen $R_I$, $C_I$, f und $N_2^*$ kann F jedoch einfach zu 1,0 gemacht werden.

c) Der Faktor F ist temperaturabhängig und nicht langzeitstabil. Sein Einfluß auf die Stabilität des Meßwerts bei Vollaussteuerung ergibt sich aus Gleichung (2) nach Rechnung näherungsweise zu :

$$\frac{dU_E}{U_E} = \frac{dF}{F} \cdot \frac{1}{N_1} \qquad (3)$$

wobei $N_1$ der Überlaufwert des Zählers Z1 aus dem ersten Meßzyklus, und dF/F die relative Drift der analogen Größen ist. Gleichung (3) besagt, daß die relative Änderung $dU_E/U_E$ des Meßwertes $U_E$ um $N_1$ mal kleiner ist als die relative Drift von F. Mit $N_1 = 100$ und dF/F = 0,01, ein Wert der mit Standardbauelementen auch langzeitig leicht realisierbar ist, ergibt sich eine relative Instabilität des Meßwertes von $10^{-4}$. Dieses ist von untergeordneter Bedeutung, umso mehr als $N_1$ noch um einige Größenordnungen erhöht und dF/F mit etwas Aufwand auf 0,001 gebracht werden kann.

Mit dem Dual-Slope-Integrator nach der Erfindung ergeben sich folgende wesentlichen Vorteile :

a) Die erforderlichen zwei Meßzyklen bringen eine Verkürzung der Meßzeit des Dual-Slope-Integrators. Aus Gleichung (2) erkennt man, daß die Gesamtauflösung des Systems $N_1 \cdot N_2$ beträgt, obwohl die maximale Taktzahl beider Zyklen bei Vollaussteuerung nur $2 \cdot (N_1 + N_2)$ beträgt. Dagegen benötigt der bekannte Dual-Slope-Integrator bei einer Auflösung von $N_1 \cdot N_2$ eine Taktzahl von $2 \cdot N_1 \cdot N_2$. Beispielsweise besitzt der konventionelle Dual-Slope-Integrator bei einer Auflösung von $10^4$ und einer Taktfrequenz von 200 kHz bei Vollaussteuerung eine Meßzeit von 100 msec. Bei gleicher Auflösung und Taktfrequenz dauert die gleiche Messung bei dem Integrator nach der Erfindung nur 2 msec, wenn $N_1 = N_2 = 100$ ist. Die Meßzeit wird also drastisch verkürzt.

b) Alle schädlichen Einflüsse des Komparators sind eliminiert. Die Fig. 1 veranschaulicht die erfindungsgemäße unter Punkt 1.3 beschriebene Signalverarbeitung in der Nähe des Nulldurchgangs der Integratorausgangsspannung. Man erkennt, daß die Unterbrechung der Bezugsspannungsintegration nicht wie bekannt durch die zeitinstabile Komparatorinformation erfolgt, sondern durch die wesentlich zeitstabilere Taktinformation. Instabile Verzögerung und Rauschen des Komparators K können die Messung nicht mehr beeinflussen.

Ein Fehlansprechen des Komparators K aufgrund der Tatsache, daß parasitäre Kapazitäten dem Integratorausgangssignal schnelle Spitzen aufprägen, wird dadurch behoben, daß der Zähler Z1 im ersten Meßzyklus von einem Impuls gestoppt wird, der gegenüber der dem Komparatorsignal folgenden Flanke des Taktgenerators T eine feste Verzögerung besitzt, die größer ist als die Breite der Nadelimpulse, die über parasitäre Kapazitäten durch die Flanken des Taktgenerators T an den Integratorausgang gelangen können, und daß eine dieser Verzögerung entsprechende feste Pulszahl durch Verlängerung der Rückwärtszählung des Zählers Z3 am Ende des zweiten Meßzyklus subtrahiert wird.

Damit wird erreicht, daß die Abschaltung der Bezugsspannung, bzw. das Festhalten der Restspannung, nicht gerade dann erfolgt, wenn sich möglicherweise eine Störspannung auf dem Integratorausgang befindet.

Der vor der virtuellen Erde des Integrators befindliche schnelle Brückenschalter S3 schließt, gesteuert durch den Taktgenerator T erst, nachdem die Einschaltzeit der Maßspannung am Eingang vollständig abgeklungen ist, und er öffnet, bevor am Eingang die Umschaltung auf die Bezugsspannung beginnt. Er schließt erst wieder taktsynchron, nachdem dieser Umschaltvorgang vollständig abgeklungen ist und wird wieder geöffnet durch das dem Komparatorausgangssignal folgende Taktsignal. Der Integrator erfährt also während eines Meßzyklus durch diesen Schalter S3 sowohl bei der Eingangsspannungsintegration als auch bei der Bezugsspannungsintegration je zwei sich exakt kompensierende Ladungsstöße, so daß keine Meßfehler verursacht werden.

Durch diese Maßnahme wird also erreicht, daß die parasitäre Ladungseinkopplung auf den Integrator des konventionellen Dual-Slope-Integrators während der Schaltvorgänge, verursacht durch unterschiedliche Tor-Senken-Kapazitäten der Feldeffekt-Transistorschalter am Eingang und durch ungeradzahlige Schaltvorgänge während eines Meßzyklus nicht mehr auftreten können.

Durch die Maßnahmen, den Schalter S3 zwischen dem Integrationswiderstand $R_I$ und der virtuellen Erde des Integrators als Brückenschaltung aus schnellen Schaltdioden aufzubauen, kann die relativ große Schaltzeit der Feldeffekt-Transistorschalter im μsec-Bereich ersetzt werden durch die wesentlich kürzere Schaltzeit einer Brücke aus schnellen Schaltdioden, die bis in den Nano-Sekunden-Bereich reichen kann. Amplituden von ca. ± 1 Volt der Schaltspannung reichen aus, um eine Brücke aus Hot-Carrier-Dioden, die mit einer Seite an der virtuellen Erde des Integrators liegt, auf- und zuzuschalten. Derart kleine Amplituden sind jedoch wesentlich leichter schnell zu schalten, als die 10 V Amplituden, die ein Feldeffekttransistor-Schalter an seinem Tor benötigt. Es ist hierbei kein Nachteil, daß der Brückenschalter S3 aus Dioden eine Versetzungsspannung im Durchlaßbereich besitzt. Sie läßt sich in die Kompensationsautomatik mit einbeziehen, die die bekannten Dual-Slope-Integratoren ohnehin für die Unterdrückung der Trennverstärker-, Integrator- und Komparator-Versetzungsspannung besitzen.

Nimmt man an, daß der Brückenschalter S3 Schaltzeitschwankungen < 1 nsec besitzt, dann kann bei einer Integrationszeit im ersten Meßzyklus von $10^4$ nsec = 10 μsec eine Auflösung von $10^4$ erreicht werden. Die Gesamtmeßzeit beider Zyklen einschließlich Einschwingzeit der Versetzungskompensation und der Feldeffekttransistor-Eingangsschalter sollte dabei < 100 μsec gemacht werden können, bei einer Taktfrequenz von nur 10 MHz.

Werden extrem kurze Konversionszeiten angestrebt, so müssen in einer Schaltung nach Fig. 2 der Schalter S3 und der aktive Integrationsverstärker I Schalt- bzw. Einschwingzeiten im nsec-Bereich besitzen. Diese Forderung ist mit konventionellen monolythischen Operationsverstärkern nicht zu erfüllen. Es stellt sich daher die Aufgabe, ein Integrationsverfahren zu finden, welches von den Einschwingzeiten der benötigten Operationsverstärker unabhängig ist.

Fig. 3 zeigt eine Schaltung eines Dual-Slope-Integrators, der diese Forderungen erfüllt und eine spannungsgesteuerte Stromquelle besitzt. Vorrichtungen zur Versetzungskompensation und Polaritätsumschaltung sind zur Vereinfachung weggelassen. Es bedeuten: Q1 spannungsgesteuerte Stromquelle, Q2 feste Stromquelle, andere Bezeichnungen wie Fig. 2. Man erkennt, daß die Auf- bzw. Entladezeiten des einseitig geerdeten Kondensators $C_1$ nur durch den Schaltzustand von S3 bestimmt werden. Einschwingvorgänge eines aktiven Integrators können die Aufladung von $C_I$ nicht mehr beeinflussen.

**Ansprüche**

1. Dual-Slope-Integrator mit Eingangsschaltern (S1, S2) für eine Meßspannung und eine Bezugsspannung, mit einem Integrator mit zumindest einem Integrationskondensator ($C_I$), mit einem Komparator (K) zur Überwachung der Spannung des Integrationskondensators ($C_I$), mit einem Taktgenerator (T) zur Erzeugung von Zählimpulsen, mit einem Zähler (Z1) der Kapazität $N_1$ zur Zählung dieser Impulse und mit einer logischen Steuerschaltung (L), die eine Torschaltstufe für die Taktimpulse enthält und in Abhängigkeit von dem Komparatorausgangssignal die Torschaltstufe sowie die genannten Eingangsschalter (S1, S2) steuert, wobei innerhalb der Steuerschaltung (L) die Schaltstufen für die Eingangsschalter (S1, S2) durch die Taktimpulse tastbar sind, dadurch gekennzeichnet, daß ein zweiter Zähler (Z2) der Kapazität $N_2$ mit dem ersten Zähler (Z1) zwecks Bildung eines Zählers (Z1 + Z2) der Gesamtkapazität $N_1 \times N_2$ in Reihe schaltbar ist, daß an den Ausgang des Integrationskondensators ($C_I$) über einen verstärker (V) mit dem Verstärkungsgrad $N_2^* = N_2$ und einem Schalter (S4) ein Haltekondensator ($C_H$) angeschaltet ist und daß der Haltekondensator (C_H) über einen weiteren Schalter (S5) an den Eingang des Integrators anschaltbar ist, wobei die Schalter (S4, S5) ebenfalls durch Taktimpulse tastbar sind und nach dem ersten Nulldurchgang der bezugsspannung schaltbar sind, damit die Restspannung des Integrators um den Verstärkungsfaktor $N_2^*$ verstärkt für einen weiteren Meßzyklus auf den Eingang zurückgeführt wird und gleichzeitig die beiden Zähler (Z1, Z2) hintereinander geschaltet werden, damit in dem weiteren Meßzyklus unter dem Einfluß der Bezugsspannung in dem Zähler (Z1 + Z2) der Zählerstand $Z_1 \times N_2 - Z_2$ gebildet wird.

2. Dual-Slope-Integrator nach Anspruch 1, dadurch gekennzeichnet, daß innerhalb der logischen Steuerschaltung (L) zur Schaltung der Taktimpulse eine Verzögerungsschaltung vorgesehen ist, deren Ausgangsschaltimpuls gegenüber der dem Komparatornulldurchgang folgenden Flanke des Taktgenerators (T) eine feste Verzögerung besitzt, die größer ist als die Breite von Störimpulsen, und daß eine der Verzögerungszeit entsprechende feste Impulszahl durch Verlängerung der Rückwärtszählung des Zählers (Z1 + Z2) am Ende des zweiten Meßzyklus subtrahiert wird.

3. Dual-Slope-Integrator nach Anspruch 1 oder 2, dadurch gekennzeichnet, daß vor der virtuellen Erde des Integrators ein Schalter (S3) vorgesehen ist, der ausschließlich den Zeitpunkt von Beginn und Ende der Integrationszyklen bestimmt.

4. Dual-Slope-Integrator nach Anspruch 3, dadurch gekennzeichnet, daß der Schalter als Brückenschaltung (S3) aus schnellen Schaltdioden aufgebaut ist.

5. Dual-Slope-Integrator nach einem der Ansprüche 1 bis 4, dadurch gekennzeichnet, daß als Integrator eine spannungsgesteuerte Stromquelle (Q_1) vorgesehen ist, an deren Ausgang ein schneller Brückenschalter (S3) und in Reihe zu demselben der Integrationskondensator (C_I) angeschaltet ist.

6. Dual-Slope-Integrator nach Anspruch 4 und 5, dadurch gekennzeichnet, daß der schnelle Brückenschalter (S3) auf Durchgang schaltbar ist, wenn alle Einschwingvorgänge der Stromquelle und der Eingangsschalter abgeklungen sind.

7. Dual-Slope-Integrator nach einem der Ansprüche 1 bis 4, dadurch gekennzeichnet, daß der Integrator einen Integrationswiderstand (R_I) aufweist und daß dieser, der Integrationskondensator (C_I), die Taktfrequenz (f) des Taktgenerators (T) und der Verstärkungsfaktor ($N_2^*$) so festgelegt sind, daß die Beziehung gilt :

$$\frac{R_I \times C_I \times f}{N_2^*} = 1$$

**Claims**

1. Dual slope integrator with input switches (S1, S2) for a test voltage and a reference voltage, with an integrator with at least one integration capacitor (C_I), with a comparator (K) to monitor the voltage of the integration capacitor (C_I) with a clock (T) to generate counting impulses, with a counter (Z1) of capacity $N_1$ to count these impulses and with a logic control circuit (L) which contains a gate switching stage for the clock impulses and controls the gate switching stage and the said input switches (S1, S2) as a function of the comparator output signal, whilst within the control circuit (L) the switching stages for the input switches (S1, S2) are keyable by the clock impulses, characterised in that a second counter (Z2) of capacity $N_2$ is connectable in series with the first counter (Z1) in order to form a counter (Z1 + Z2) of the total capacity $N_1 \times N_2$, that a holding capacitor (C_H) is connected to the output of the integration capacitor (C_I) through an amplifier (V) with the gain factor $N_2^* = N_2$ and a switch (S4), and that the holding capacitor (C_H) is connectable through a further switch (S5) to the input of the integrator, whilst the switches (S4, S5) are likewise keyable by the clock impulses and are switchable after the first zero transit of the reference voltage so that the residual voltage of the integrator, amplified by the gain factor $N_2^*$, is fed back to the input for a further test cycle, and simultaneously the two counters (Z1, Z2) are connected in series, so that in the further test cycle the counter state $Z_1 \times N_2 - Z_2$ is formed in the counter (Z1 + Z2) under the influence of the reference voltage.

2. Dual slope integrator according to Claim 1, characterised in that a delay circuit is provided within the logic control circuit (L) in order to switch the clock impulses, the output switching impulse of which has a fixed delay with reference to the flank of the clock (T) following the comparator zero transit which is greater than the width of noise impulses, and that a fixed number of impulses corresponding to the delay time is subtracted by prolonging the reverse counting of the counter (Z1 + Z2) at the end of the second test cycle.

3. Dual slope integrator according to Claim 1 or 2, characterised in that a switch (S3) which exclusively determines the time of start and finish of the integration cycles is provided before the virtual earth of the integrator.

4. Dual slope integrator according to Claim 3, characterised in that the switch is constructed as a bridge circuit (S3) made of high-speed switching diodes.

5. Dual slope integrator according to any of Claims 1 to 4, characterised in that, as integrator, a voltage-controlled current source (Q_1) is provided, to the output of which a high-speed bridge switch (S3) and in series therewith the integration capacitor (C_I) are connected.

6. Dual slope integrator according to Claims 4 and 5, characterised in that the high-speed bridge switch (S3) is switchable to « straight through » when all the onset phenomena of the current source and of the input switches have decayed.

7. Dual slope integrator according to any of Claims 1 to 4, characterised in that the integrator exhibits an integration resistor ($R_I$) and that the latter, the integration capacitor ($C_I$), the clock frequency (f) of the clock (T) and the gain factor ($N_2{}^*$) are determined so that the relationship

$$\frac{R_I \times C_I \times f}{N_2{}^*} = 1$$

is valid.

## Revendications

1. Intégrateur à double rampe qui comporte des commutateurs d'entrée (S1, S2) pour une tension à mesurer et une tension de référence, un intégrateur qui comporte au moins un condensateur d'intégration ($C_I$), un comparateur (K) pour surveiller la tension du condensateur d'intégration ($C_I$), un générateur de cadence (T) pour produire des impulsions de comptage, un compteur (Z1) de capacité $N_1$ pour compter ces impulsions, et un circuit de commande logique (L) qui comprend un circuit de commutation à porte pour les impulsions de cadence et qui commande le circuit de commutation à porte ainsi que lesdits commutateurs (S1, S2) en fonction du signal de sortie du comparateur, les circuits de commutation du commutateur d'entrée (S1, S2) pouvant être commandés par les impulsions de cadence, à l'intérieur du circuit de commande (L), caractérisé par le fait qu'un second compteur (Z2) de capacité $N_2$ peut être branché en série avec le premier compteur (Z1) pour former un compteur (Z1 + Z2) de capacité globale $N_1 \times N_2$, qu'un condensateur de maintien ($C_H$) est branché à la sortie du condensateur d'intégration ($C_I$) par l'intermédiaire d'un amplificateur (V) possédant un gain $N_2{}^* = N_2$ et d'un commutateur (S4), et que le condensateur de maintien ($C_H$) peut être relié à l'entrée de l'intégrateur par l'intermédiaire d'un autre commutateur (S5), les commutateurs (S4, S5) pouvant également être commandés par les impulsions de cadence et pouvant être commutés après le premier passage par zéro de la tension de référence afin que la tension résiduelle de l'intégrateur, amplifiée du gain $N_2{}^*$, soit ramenée à l'entrée pour un autre cycle de mesure et que simultanément les deux compteurs (Z1, Z2) soient branchés l'un derrière l'autre, pour obtenir l'état de comptage $Z_1 \times N_2 - Z_2$ dans le compteur (Z1 + Z2), sous l'action de la tension de référence, dans l'autre cycle de mesure.

2. Intégrateur à double rampe suivant la revendication 1, caractérisé par le fait que pour appliquer les impulsions de commande, il est prévu à l'intérieur du circuit de commutation logique (L) un circuit de retard dont l'impulsion de commutation de sortie possède, par rapport au flanc du générateur de cadence (T) qui suit le passage par zéro du comparateur, un retard fixe qui est plus important que la largeur d'impulsions perturbatrices, et qu'un nombre d'impulsions fixe correspondant au retard est soustrait à la fin du second cycle de mesure par prolongation du comptage à rebours du compteur (Z1 + Z2).

3. Intégrateur à double rampe suivant l'une des revendications 1 ou 2, caractérisé par le fait qu'avant la terre virtuelle de l'intégrateur est prévu un commutateur (S3) qui détermine exclusivement l'instant du début et de la fin des cycles d'intégration.

4. Intégrateur à double rampe suivant la revendication 3, caractérisé par le fait que le commutateur se présente sous la forme d'un circuit en pont (S3) constitué par des diodes de commutation rapides.

5. Intégrateur à double rampe suivant les revendications 1 à 4, caractérisé par le fait qu'en tant qu'intégrateur est prévue une source de courant commandée en tension ($Q_1$) à la sortie de laquelle sont reliés un commutateur en pont rapide (S3) et, en série avec celui-ci, le condensateur d'intégration ($C_I$).

6. Intégrateur à double rampe suivant la revendication 4 ou 5, caractérisé en ce que le commutateur en pont rapide (S3) peut être rendu passant lorsque tous les phénomènes transitoires de la source de courant et du commutateur d'entrée ont disparu.

7. Intégrateur à double rampe suivant les revendications 1 à 4, caractérisé en ce que l'intégrateur comporte une résistance d'intégration ($R_I$) et que celle-ci, le condensateur d'intégration ($C_I$), la fréquence de cadence (f) du générateur de cadence (T) et le gain ($N_2{}^*$) sont déterminés de manière à satisfaire à la relation :

$$\frac{R_I \cdot C_I \cdot f}{N_2{}^*} = 1$$

**Fig. 1**

**Fig. 2**

*Fig. 3*